# EUROPÄISCHE PATENTSCHRIFT

(11) **EP 2 022 206 B1**
(45) Veröffentlichungstag und Bekanntmachung des Hinweises auf die Patenterteilung: **14.03.2012**
(21) Anmeldenummer: 06753246.5
(22) Anmeldetag: 31.05.2006
(51) Int. Cl.: H04L 7/027, H03L 7/00

(54) **TAKTRÜCKGEWINNUNGSEINRICHTUNG UND VERFAHREN ZUM TAKTRÜCKGEWINNEN**
CLOCK SIGNAL RECOVERY DEVICE AND METHOD FOR RECOVERING CLOCK SIGNALS
DISPOSITIF DE RÉCUPÉRATION D'HORLOGE ET PROCÉDÉ DE RÉCUPÉRATION D'HORLOGE

(43) Veröffentlichungstag der Anmeldung: 11.02.2009
(73) Patentinhaber: SIEMENS AKTIENGESELLSCHAFT, 80333 München (DE)
(72) Erfinder: HOCHLEITNER, Josef, 91074 Herzogenaurach (DE); KARL, Harald, 90765 Fürth (DE)
(86) Internationale Anmeldenummer: PCT/DE2006/000971
(87) Internationale Veröffentlichungsnummer: WO 2007/137538

(56) Entgegenhaltungen:
- US-A- 5 721 890
- US-A1- 2002 090 044
- WITTE H-H ET AL: "SIMPLE CLOCK EXTRACTION CIRCUIT USING A SELF SUSTAINING MONOSTABLE MULTIVIBRATOR OUTPUT SIGNAL" ELECTRONICS LETTERS, IEE STEVENAGE, GB, Bd. 19, Nr. 21, 13. Oktober 1983 (1983-10-13), Seiten 897-898, XP000808593 ISSN: 0013-5194
- KEN YANG C K: "Timing Recovery" INTERNET CITATION, [Online] 4. Juni 2001 (2001-06-04), XP002264983 Gefunden im Internet: URL:www.icsl.ucla.edu/~yang/ee219a/ee219a_ lect_crc.pdf> [gefunden am 2003-12-12]

## Beschreibung

Die Erfindung bezieht sich auf eine Taktrückgewinnungseinrichtung mit einem digitalen Datensignaleingang zum Einspeisen eines eine vorgegebene nominale Taktfrequenz aufweisenden digitalen Datensignals und einem Taktausgang zur Ausgabe eines rückgewonnenen Taktsignals.

Aus der Druckschrift "Simple clock extraction circuit using a self sustaining monostable multivibrator output signal" (Witte et al., Electronics Letters, IEE Stevenage, GB, Bd. 19, Nr. 21, 13.10.1983, Seiten 897-898, ISSN: 0013-5194) ist eine Taktrückgewinnungseinrichtung mit den Merkmalen gemäß dem Oberbegriff des Patentanspruchs 1 bekannt. Bei dieser Taktrückgewinnungseinrichtung wird der Takt allein aus dem Datensignal zurückgewonnen. Eine ähnliche Taktrückgewinnungseinrichtung ist in der US-Offenlegungsschrift US 2002/0090044 A1 beschrieben.

Bekanntermaßen verwenden moderne synchrone Kommunikationsprotokolle auf der physikalischen Übertragungsschicht häufig eine auf der 4B/5B- oder 8B/10B-Kodierung basierende Leitungs- bzw. Datenkodierung. Dabei werden die Daten und der Takt in einem Kodierbaustein zu einem einzigen Bitstrom vereint, der nachfolgend über ein Übertragungsmedium wie z. B. Funk oder Lichtwellenleiter gesendet wird. Im Rahmen der Kodierung werden die 4B- bzw. 8B-Datensignale durch ein Hinzufügen weiterer Bits auf 5 bzw. 10 Bit breite Datensymbole erweitert. Durch dieses Hinzufügen der weiteren Bits werden die Gleichstromfreiheit des Sendesignals sowie zusätzlich eine ausreichende Anzahl von Bit-Wechseln bzw. Flanken im Bitstrom gewährleistet. Anschließend werden die Datensymbole nach bekannten Verfahren wieder in den ursprünglichen Dateninhalt, also in 4 Bit- bzw. 8Bit-Datensignale, dekodiert.

Die Rekonstruktion des Taktsignals aus dem empfangenen Datenbitstrom kann bekanntermaßen mit Hilfe von analogen Phasenregelkreisen, üblicherweise PLL-Phasenregelkreisen, erfolgen. Bei diesen analogen PLL-Phasenregelkreisen werden die Frequenz und die Phase eines steuerbaren Taktgenerators so lange verändert, bis dessen Taktflanken mit den Flanken des Datensignals übereinstimmen. Anschließend wird der eingangsseitig anliegende Datenbitstrom mit dem so erzeugten Takt abgetastet und unter Zuhilfenahme eben dieses Taktes dekodiert. Die zum Erzeugen des Taktes notwendigen Phasenregelkreise benötigen jedoch sehr spezielle analoge Schaltungen, die kostenaufwendig sind.

Der Erfindung liegt demgemäß die Aufgabe zugrunde, eine Taktrückgewinnungseinrichtung anzugeben, die sich kostengünstiger als bisherige Taktrückgewinnungseinrichtungen realisieren lässt.

Diese Aufgabe wird erfindungsgemäß durch eine Taktrückgewinnungseinrichtung mit den Merkmalen gemäß Patentanspruch 1 gelöst. Vorteilhafte Ausgestaltungen der erfindungsgemäßen Taktrückgewinnungseinrichtung sind in Unteransprüchen angegeben.

Ein wesentlicher Vorteil der erfindungsgemäßen Taktrückgewinnungseinrichtung ist darin zu sehen, dass diese ohne Zuhilfenahme analoger Komponenten hergestellt werden kann und somit beispielsweise ausschließlich unter Verwendung von Standard-Logikbausteinen, wie z. B. FPGA- (FPGA: frei programmierbare Gatearrays) oder ASIC-Bausteinen realisiert werden kann.

Besonders einfach und damit vorteilhaft lässt sich eine solche Taktrückgewinnungseinrichtung bilden, wenn diese eine Signalwechselerkennungseinrichtung aufweist, die Signalwechsel zumindest eines vorgegebenen Signalwechseltyps des Datensignals erkennt und bei jedem Signalwechsel jeweils einen Puls erzeugt. Die Signalwechselerkennungseinrichtung kann beispielsweise einen Signalwechsel von einer logischen 0 auf eine logische 1 oder stattdessen auch von einer logischen 1 auf eine logische 0 erkennen. Alternativ ist es auch möglich, die Signalwechselerkennungseinrichtung derart auszugestalten, dass sie beide Arten von Signalwechseln, also von 0 und 1 und umgekehrt, erkennen kann.

Die Taktrückgewinnungseinrichtung weist vorzugsweise außerdem eine Hilfspulserzeugungseinrichtung auf, die mit der nominalen Taktfrequenz des Datensignals Hilfspulse erzeugt. Eine mit der Signalwechselerkennungseinrichtung und der Hilfspulserzeugungseinrichtung in Verbindung stehende Ausgabeeinrichtung ist vorzugsweise derart ausgestaltet, dass sie bei Vorliegen eines Pulses sowie auch bei Vorliegen eines Hilfspulses jeweils einen Ausgangspuls bildet und mit den so gebildeten Ausgangspulsen das rückgewonnene Taktsignal erzeugt.

Im Hinblick auf eine möglichst schnelle Anpassung der Phasenlage des rückgewonnenen Taktsignals an die Phasenlage des digitalen Datensignals wird es als vorteilhaft angesehen, wenn die Hilfspulserzeugungseinrichtung eingangsseitig mit einem Ausgang der Ausgabeeinrichtung in Verbindung steht und derart ausgestaltet ist, dass die Erzeugung der Hilfspulse zeitlich durch Signalwechsel des rückgewonnenen Taktsignals gesteuert, insbesondere getriggert bzw. ausgelöst, wird.

Die Hilfspulserzeugungseinrichtung kann beispielsweise derart ausgestaltet sein, dass sie nach jedem Ausgangspuls des rückgewonnenen Taktsignals, und zwar beispielsweise nach Ablauf einer der nominalen Taktfrequenz entsprechenden Periodendauer, jeweils einen Hilfspuls erzeugt.

Die Ausgabeeinrichtung lässt sich besonders einfach und damit vorteilhaft mit einem einfachen Flip-Flop, insbesondere einem D-Flip-Flop, bilden.

Vorzugsweise bildet das Flip-Flop gemeinsam mit der Hilfspulserzeugungseinrichtung einen binären Zähler, der binär zumindest bis zum vorgegebenen Vielfachen zählen kann. Beträgt das vorgegebene Vielfache beispielsweise 3, so lässt sich der binäre Zähler beispielsweise aus zwei D-Flip-Flops, von denen eine die Ausgabeeinrichtung bildet, sowie einem UND-Gatter zusammensetzen.

Die digitale Schaltung der Taktrückgewinnungseinrichtung wird vorzugsweise ausschließlich durch digitale Gatter oder Flip-Flops gebildet, da derartige Komponenten in Standard FPGA-Bausteinen oder ähnlichen Komponenten wie ASIC-Bausteinen standardmäßig vorhanden sind.

Als selbständige Erfindung wird außerdem ein Verfahren zum Bilden eines rückgewonnenen Taktsignals aus einem digitalen Datensignal angesehen, das eine vorgegebene nominale Taktfrequenz aufweist. Erfindungsgemäß sind diesbezüglich die Merkmale des Anspruchs 9 vorgesehen.

Gemäß einer bevorzugten Ausgestaltung dieses Verfahrens ist vorgesehen, dass mit der Generatorfrequenz das Datensignal abgetastet wird und Signalwechsel zumindest eines vorgegebenen Signalwechseltyps des Datensignals erkannt werden. Bei jedem erkannten Signalwechsel wird ein Puls erzeugt. Außerdem werden mit der nominalen Taktfrequenz des Datensignals Hilfspulse erzeugt, und bei Vorliegen eines Pulses oder eines Hilfspulses wird jeweils ein Ausgangspuls gebildet. Mit den so gebildeten Ausgangspulsen wird das rückgewonnene Taktsignal erzeugt.

Die Erfindung wird nachfolgend anhand von Ausführungsbeispielen näher erläutert, dabei zeigen beispielhaft:
- Figur 1: ein Ausführungsbeispiel für eine erfindungsgemäße Taktrückgewinnungseinrichtung, anhand derer auch das erfindungsgemäße Verfahren beispielhaft näher erläutert wird,
- Figur 2: die bei der Taktrückgewinnungseinrichtung gemäß Figur 1 auftretenden Signalverläufe für den beispielhaften Fall, dass das rückgewonnene Taktsignal einen zeitlich verlängerten Ausgangspuls aufweist,
- Figur 3: die bei der Taktrückgewinnungseinrichtung gemäß Figur 1 auftretenden Signalverläufe für den beispielhaften Fall, dass das rückgewonnene Taktsignal einen zeitlich verkürzten Pulsabstand aufweist, und
- Figur 4: beispielhaft den Aufbau eines Datenpakets eines Datensignals für die Taktrückgewinnungseinrichtung gemäß Figur 1.

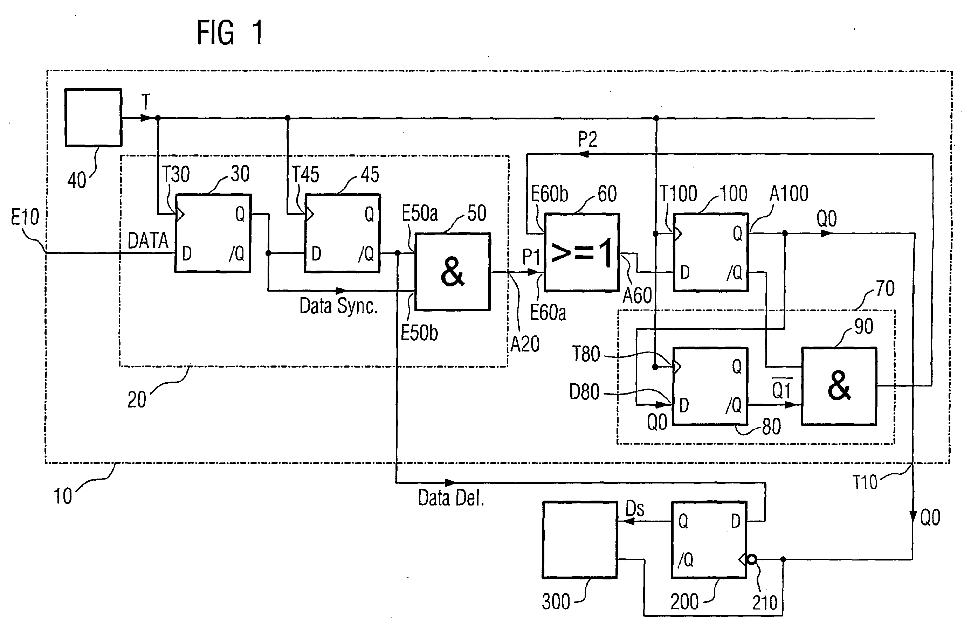

In den Figuren 1 bis 4 werden für identische oder vergleichbare Komponenten oder Signale stets dieselben Bezugszeichen verwendet. Im Übrigen wird beispielhaft davon ausgegangen, dass alle Abtastungen mit der positiven Taktflanke erfolgen, sofern im Einzelfall nichts anderes angegeben ist.

In der Figur 1 erkennt man ein Ausführungsbeispiel für eine Taktrückgewinnungseinrichtung 10. Die Taktrückgewinnungseinrichtung 10 weist an ihrem digitalen Datensignaleingang E10 eine Signalwechselerkennungseinrichtung 20 auf, in die sich ein digitales, beispielsweise synchrones Datensignal DATA einspeisen lässt. Eingangsseitig ist die Signalwechselerkennungseinrichtung 20 mit einem D-Flip-Flop 30 ausgestattet, dessen D-Signaleingang mit dem Datensignal DATA beaufschlagt ist. Ein Takteingang T30 des D-Flip-Flops 30 ist mit einem freilaufenden Taktgenerator 40 verbunden, der ausgangsseitig ein Taktsignal T mit einer Generatorfrequenz ft erzeugt.

Die Generatorfrequenz ft ist derart gewählt, dass sie beispielsweise einem ganzzahligen Vielfachen der nominalen Taktfrequenz fn des Datensignals DATA entspricht. Nachfolgend wird beispielhaft davon ausgegangen, dass die nominale Taktfrequenz fn des Datensignals DATA fn = 125 MHz beträgt, so dass die Generatorfrequenz ft für den Fall eines Vielfachen von drei demgemäß einen Wert von ft = 375 MHz aufweist.

Eine nominale Taktfrequenz von 125 MHz tritt beispielsweise bei Datensignalen auf, die im Fast-Ethernet 100BaseFX-Standard übertragen werden. Der Fast-Ethernet-Standard arbeitet üblicherweise mit einer Datenrate von 100 MBit pro Sekunde, so dass bei einer 4B/5B-Kodierung eine Leitungskodierung bzw. Baud-Rate von 125 MBaud bzw. eine entsprechende Taktfrequenz von 125 MHz auftritt.

Dem D-Flip-Flop 30 ist ausgangsseitig ein weiteres D-Flip-Flop 45 nachgeschaltet, dessen Takteingang T45 ebenfalls mit dem freilaufenden Taktgenerator 40 verbunden ist. Der invertierte Ausgang /Q des weiteren D-Flip-Flops 45 ist ausgangsseitig mit einem Eingang E50a eines UND-Gliedes 50 verbunden. Ein weiterer Eingang E50b dieses UND-Gliedes 50 ist an den Ausgang Q des D-Flip-Flops 30 angeschlossen. An den beiden Eingängen E50a und E50b des UND-Gliedes 50 liegen somit das von dem weiteren D-Flip-Flop 45 ausgangsseitig gebildete Signal "Data Del." sowie das Ausgangssignal "Data Sync" des D-Flip-Flops 30 an.

Das Ausgangssignal des UND-Gliedes 50 ist in der Figur 1 mit dem Bezugszeichen P1 gekennzeichnet; dieses wird an einem Ausgang A20 der Signalwechseleinrichtung 20 abgegeben und damit in einen Eingang E60a eines ODER-Gliedes 60 eingespeist. Ein weiterer Eingang E60b des ODER-Gliedes 60 ist mit Hilfspulsen P2 einer Hilfspulserzeugungseinrichtung 70 beaufschlagt.

Die Hilfspulserzeugungseinrichtung 70 weist eingangsseitig ein D-Flip-Flop 80 auf, dem ein UND-Glied 90 nachgeordnet ist. Der Ausgang des UND-Gliedes 90 erzeugt die Hilfspulse P2, die zu dem weiteren Eingang E60b des ODER-Gliedes 60 gelangen.

Ein Takteingang T80 des D-Flip-Flops 80 ist mit dem freilaufenden Taktgenerator 40 verbunden; der D-Signaleingang D80 des D-Flip-Flops 80 steht mit dem Q-Ausgang eines eine Ausgabeeinrichtung bildenden D-Flip-Flops 100 in Verbindung. Der Takteingang T100 des D-Flip-Flops 100 ist mit dem freilaufenden Taktgenerator 40 verbunden, und der D-Signaleingang des D-Flip-Flops 100 steht mit dem Ausgang A60 des ODER-Gliedes 60 in Verbindung.

Wie sich in der Figur 1 darüber hinaus erkennen lässt, ist mit der Taktrückgewinnungseinrichtung 10 außerdem eine Abtasteinrichtung 200 verbunden, die das von dem weiteren D-Flip-Flop 45 der Signalwechselerkennungseinrichtung 20 gebildete verzögerte Datensignal "Data Del." mit dem am Taktausgang T10 der Taktrückgewinnungseinrichtung 10 abgegebenen "rückgewonnenen" Taktsignal Q0, und zwar mit dessen abfallender Flanke, abtastet. Alternativ könnte auch das invertierte Signal /Q0 des Flip-Flops 100 für ein Abtasten mit der positiven Flanke verwendet werden; in diesem Falle wäre der Inverter 210 vor dem Takteingang des Flip-Flops 200 überflüssig.

Wie weiter unten noch eingehender beschrieben wird, bilden das D-Flip-Flop 80 sowie das UND-Glied 90 der Hilfspulserzeugungseinrichtung 70 sowie das D-Flip-Flop 100 gemeinsam einen Zähler, der binär drei Zahlenwerte annehmen kann, nämlich die binären Zahlenwerte "11", "10" und "01" an den /Q-Ausgängen der beiden Flip-Flops 80 und 100 sowie die binären Zahlenwerte "00", "10" und "01" an den Q-Ausgängen der beiden Flip-Flops 80 und 100.

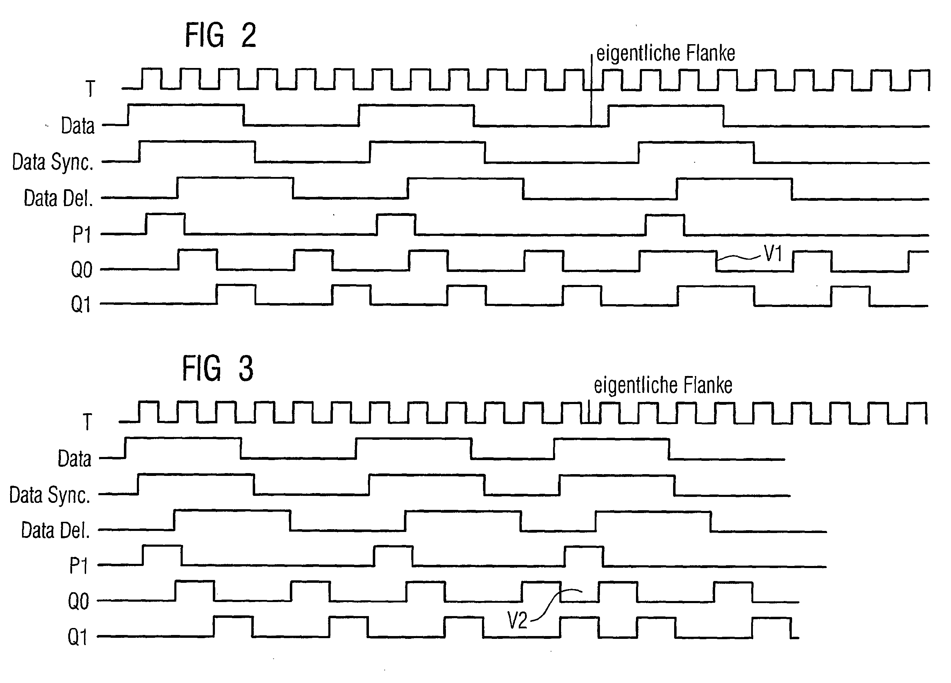

Die Funktionsweise der Taktrückgewinnungseinrichtung 10 gemäß Figur 1 wird nachfolgend anhand der Figuren 2 und 3 näher erläutert:
Man erkennt in der Figur 2 das Taktsignal T des freilaufenden Taktgenerators 40, das eine Taktfrequenz ft = 375 MHz aufweist. Unterhalb des Taktsignals T ist das Datensignal DATA dargestellt, dessen Verlauf hier nur beispielhaft zu verstehen ist. Das Datensignal DATA kann beispielsweise ein 4B/5B-kodiertes Signal sein, das in einem Ethernet-kompatiblen Format übertragen wird.

Das Datensignal DATA gelangt zu dem D-Flip-Flop 30 der Signalwechselerkennungseinrichtung 20, das ausgangsseitig das geringfügig verzögerte Datensignal "Data Sync" erzeugt. Das Signal "Data Sync" wird in das weitere D-Flip-Flop 40 eingespeist, das ausgangsseitig ein noch weiter verzögertes Signal, nämlich das Signal "Data Del." (Del: Delayed bzw. verzögert) bildet.

Mit den beiden Signalen "Data Del." und "Data Sync" bildet das UND-Glied 50 ausgangsseitig die Pulse P1, die anschaulich betrachtet jeweils Signalwechsel des Datensignals DATA signalisieren. Da nun das Datensignal DATA weniger häufig Signalwechsel aufweist, als dies der Taktfrequenz ft = 125 MHz des Datensignals DATA entsprechen würde, weist das Ausgangssignal des UND-Glieds 50 dementsprechend ebenfalls weniger Pulse P1 auf, als dies dem nominalen Takt fn des Datensignals DATA entspricht.

Um nun ein rückgewonnenes Taktsignal Q0 zu erzeugen, müssen also noch weitere Pulse, nachfolgend Hilfspulse genannt, gebildet werden. Die Erzeugung der Hilfspulse erfolgt durch die Hilfspulserzeugungseinrichtung 70, die mit der nominalen Taktfrequenz des Datensignals DATA die Hilfspulse P2 erzeugt und diese zu dem ODER-Glied 60 überträgt. Die Hilfspulse P2 weisen dabei eine der nominalen Taktfrequenz des Datensignals DATA entsprechende Frequenz auf, da durch die beiden Flip-Flops 80 und 100 sowie das UND-Glied 90 ein Frequenzteiler gebildet wird, der den Generatortakt ft des Taktgenerators 40 um den Faktor 3 heruntersetzt. Die Hilfspulse P2 entsprechen somit bis auf ihre Phasenlage schon relativ genau dem Takt des eingangsseitig anliegenden Datensignals DATA.

Sobald nun an dem ODER-Glied 60 entweder ein Hilfspuls P2 oder ein Puls P1 anliegt, so wird dieser an den D-Eingang des Flip-Flops 100 durchgereicht, so dass ausgangsseitig ein Signal Q0 mit einer logischen 1 erzeugt wird, sobald vom Taktgenerator 40 ein entsprechendes Triggersignal erzeugt und zum Takteingang T100 des Flip-Flops 100 weitergeleitet wird.

Der zeitliche Verlauf der von dem D-Flip-Flop 100 gebildeten Ausgangspulse, die gleichzeitig auch das rückgewonnene Taktsignal Q0 der Taktrückgewinnungseinrichtung 10 bilden, ist in der Figur 2 im zeitlichen Verlauf gezeigt. Man erkennt, dass es aufgrund der Überlagerung der Pulse P1 und der Hilfspulse P2 zu einer Synchronisierung des rückgewonnenen Taktsignals Q0 relativ zum Datensignal DATA kommt, indem beispielsweise eine Pulsverlängerung oder eine Abstandsverkürzung auftritt.

Ein verlängerter Ausgangspuls ist in der Figur 2 mit dem Bezugszeichen V1 gekennzeichnet.

Anstelle einer Pulsverlängerung kann es aufgrund der Überlagerung der Pulse P1 und der Hilfspulse P2 auch zu einer Verkürzung der zeitlichen Abstände zwischen den Ausgangspulsen Q0 des D-Flip-Flops 100 kommen; dies ist beispielhaft in der Figur 3 dargestellt. Der verkürzte Abstand ist in der Figur 3 mit dem Bezugszeichen V2 gekennzeichnet.

Mit dem rückgewonnenen Taktsignal Q0 kann nun das verzögerte Datensignal "Data Del." mit der negativen Flanke abgetastet werden; hierzu wird das eine Abtasteinrichtung bildende D-Flip-Flop 200 gemäß Figur 1 eingesetzt. Ausgangsseitig wird dabei ein synchronisiertes Abtastsignal Ds gebildet, das wiederum mit einer aus dem Stand der Technik bekannten Dekodiereinheit, die beispielsweise nach dem 4B/5B-Verfahren arbeitet, ausgewertet werden kann. Die entsprechende Dekodiereinheit ist in der Figur 1 mit dem Bezugszeichen 300 gekennzeichnet.

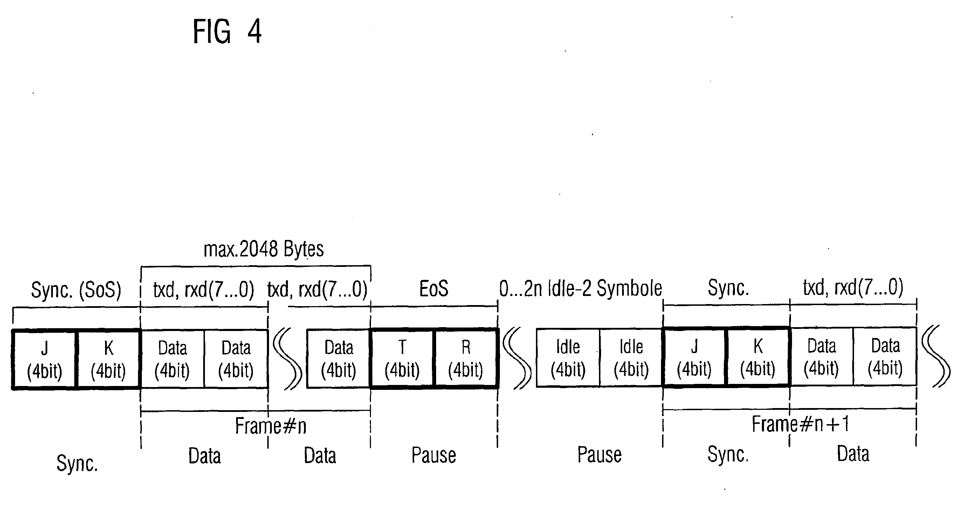

In der Figur 4 ist beispielhaft dargestellt, wie das Datensignal DATA bitmäßig aufgebaut sein kann. Man erkennt in der Figur 4, dass jeweils zu Beginn eines Datenstromes die Symbolkombination J/K als Synchronisationszeichen gesendet wird, so dass empfangsseitig der Beginn einer Datenpaketübertragung festgestellt werden kann. Nach dem Ende einer Datenpaketübertragung werden vorzugsweise ausschließlich Signalwechsel übertragen, bis ein nächstes Synchronisationszeichen in Form einer Symbolkombination J/K den Beginn eines nächsten Datenpaketes symbolisiert. Die Signalwechsel zwischen einzelnen Datenpakten sind in der Figur 4 mit dem Begriff "Idle" gekennzeichnet.

In der Dekodiereinheit 300 gemäß der Figur 1 kann beispielsweise ein Schieberegister enthalten sein, das mit dem rückgewonnenen Taktsignal Q0 der Taktrückgewinnungseinrichtung 10 betrieben wird. An einem parallelen Ausgang des Schieberegisters wird bei jedem Taktwechsel überprüft, ob ein charakteristisches Bitmuster aufgefunden wird: Ein solches charakteristisches Bitmuster kann beispielsweise durch ein Synchronisationszeichen gebildet sein, das dem in Figur 4 dargestellten Synchronisationssymbol J/K entspricht. Ist dies der Fall, so kann mit der Auswertung der eingangsseitig anliegenden Datensignale DATA begonnen werden.

Bei dem Ausführungsbeispiel gemäß Figur 1 wurde beispielhaft davon ausgegangen, dass das Datensignal DATA mit einer Generatorfrequenz abgetastet wird, die dem Dreifachen der nominalen Taktfrequenz des Datensignals entspricht. Alternativ kann auch eine höhere Taktfrequenz zum Abtasten des Datensignals verwendet werden. Beträgt die Generatorfrequenz ft des Taktgenerators 40 das n-fache der Baudrate bzw. der nominalen Frequenz fn des Datensignals DATA, so kann der regenerierte Takt Q0 am Ausgang des Flip-Flops 100 einen zeitlichen Abstand zum Takt des Datensignals von (n-1)*Ta, n*Ta und (n+1)*Ta aufweisen, wobei Ta die Periodendauer des Taktsignals T bezeichnet.

Das beschriebene Taktrückgewinnungsverfahren kann mit digitalen Schaltkreisen, z. B. mit ASIC- oder FPGA-Bausteinen, durchgeführt werden, weil nur Gatter und Flip-Flops und keine analogen Elemente wie Zeitverzögerungselemente oder dergleichen benötigt werden. Das Verfahren kann beispielsweise in Sendern und Empfängern implementiert werden, die gemäß einer 4B/5B- oder einer 8B/10B-Leitungskodierung arbeiten.

Außerdem ist das beschriebene Verfahren mit allen Kommunikationsprotokollen kompatibel, beispielsweise auch mit dem Fast-Ethernet 100BaseFX -Protokoll. Beträgt die Datenrate beispielsweise 100 MBit pro Sekunde (=125 MBaud), so kann bereits mit einem Generatortakt von 375 MHz auf rein digitale Weise ein Taktsignal zurückgewonnen werden, mit dem sich eine Auswertung eines eingangsseitig anliegenden digitalen Datensignals durchführen lässt.

Die beschriebene Taktrückgewinnung lässt sich in vielen technischen Gebieten nutzen, insbesondere auch im Bereich von Magnetschwebebahnen.

### Bezugszeichenliste

- 10: Taktrückgewinnungseinrichtung
- 20: Signalwechselerkennungseinrichtung
- 30: D-Flip-Flop
- 40: Taktgenerator
- 45: weiteres D-Flip-Flop
- 50: UND-Glied
- 60: ODER-Glied
- 70: Hilfspulserzeugungseinrichtung
- 80: D-Flip-Flop
- 90: UND-Glied
- 100: D-Flip-Flop
- 200: Abtasteinrichtung
- 210: Inverter
- 300: Dekodiereinheit
- A20: Ausgang
- A60: Ausgang
- E10: Signaleingang
- E50a,E50b: Eingänge
- E60a,60b: Eingänge
- T80: Takteingang
- T100: Takteingang
- D80: Dateneingang
- DATA: Datensignal
- Data Syn.: Datensignal
- Data Del.: verzögertes Signal
- fn: nominale Taktfrequenz
- ft: Generatorfrequenz
- Idle: Signalwechsel
- J/K: Synchronisationszeichen
- P1: Pulse
- P2: Hilfspulse
- Q0: rückgewonnenes Taktsignal
- T: Generatortakt
- Ta: Periodendauer
- V: verlängerter Ausgangspuls
- V2: verkürzter Pulsabstand

## Patentansprüche

1. Taktrückgewinnungseinrichtung (10) mit einem digitalen Datensignaleingang (E10) zum Einspeisen eines digitalen Datensignals (DATA) und mit einem Taktausgang (T10) zur Ausgabe eines rückgewonnenen Taktsignals (Q0), wobei das digitale Datensignal eine vorgegebene nominale Taktfrequenz aufweist, wobei die Taktrückgewinnungseinrichtung durch eine digitale Schaltung gebildet ist und eine Signalwechselerkennungseinrichtung (20) aufweist, die Signalwechsel zumindest eines vorgegebenen Signalwechseltyps des Datensignals erkennt und bei jedem Signalwechsel einen Puls (P1) erzeugt,
**dadurch gekennzeichnet, dass**
- die Taktrückgewinnungseinrichtung einen freilaufenden Taktgenerator (40) umfasst, dessen Generatorfrequenz ein vorgegebenes Vielfaches der nominalen Taktfrequenz des Datensignals aufweist, wobei das vorgegebene Vielfache ein ganzzahliges Vielfaches ist und mindestens drei beträgt, und
- die Signalwechselerkennungseinrichtung mit dem Ausgangssignal (T) des Taktgenerators beaufschlagt ist und die Signalwechsel des Datensignals durch ein Überabtasten mit der Generatorfrequenz erkennt.

2. Taktrückgewinnungseinrichtung nach Anspruch 1,
**dadurch gekennzeichnet, dass**
die Taktrückgewinnungseinrichtung aufweist:
- eine Hilfspulserzeugungseinrichtung (70), die mit der nominalen Taktfrequenz des Datensignals Hilfspulse (P2) erzeugt, und
- eine mit der Signalwechselerkennungseinrichtung und der Hilfspulserzeugungseinrichtung in Verbindung stehenden Ausgabeeinrichtung (100), die bei Vorliegen eines Pulses (P1) und bei Vorliegen eines Hilfspulses (P2) jeweils einen Ausgangspuls bildet und mit den so gebildeten Ausgangspulsen das rückgewonnene Taktsignal (Q0) erzeugt.

3. Taktrückgewinnungseinrichtung nach Anspruch 2,
**dadurch gekennzeichnet, dass**
die Hilfspulserzeugungseinrichtung eingangsseitig mit einem Ausgang (100) der Ausgabeeinrichtung (A100) in Verbindung steht und derart ausgestaltet ist, dass die Erzeugung der Hilfspulse (P2) zeitlich durch Ausgangspulse des rückgewonnenen Taktsignals (Q0) gesteuert wird.

4. Taktrückgewinnungseinrichtung nach Anspruch 2 oder 3,
**dadurch gekennzeichnet, dass**
die Hilfspulserzeugungseinrichtung derart ausgestaltet ist, dass sie nach Ablauf einer der nominalen Taktfrequenz entsprechenden Periodendauer - oder einem Vielfachen davon - nach einem Ausgangspuls des rückgewonnenen Taktsignals (Q0) jeweils einen Hilfspuls (P2) erzeugt.

5. Taktrückgewinnungseinrichtung nach einem der voranstehenden Ansprüche 2-4,
**dadurch gekennzeichnet, dass**
die Ausgabeeinrichtung durch ein Flip-Flop (100) gebildet ist.

6. Taktrückgewinnungseinrichtung nach Anspruch 5,
**dadurch gekennzeichnet, dass**
das Flip-Flop (100) gemeinsam mit der Hilfspulserzeugungseinrichtung einen binären Zähler bildet, der binär zumindest bis zum dem vorgegebenen Vielfachen zählen kann.

7. Taktrückgewinnungseinrichtung nach einem der voranstehenden Ansprüche,
**dadurch gekennzeichnet, dass**
die digitale Schaltung ausschließlich durch digitale Gatter oder Flipflops gebildet ist.

8. Taktrückgewinnungseinrichtung nach einem der voranstehenden Ansprüche,
**dadurch gekennzeichnet, dass**
die digitale Schaltung in einem FPGA- oder ASIC-Baustein realisiert ist.

9. Verfahren zum Erzeugen eines rückgewonnenen Taktsignals (Q0) aus einem digitalen Datensignal (DATA), das eine vorgegebene nominale Taktfrequenz aufweist, wobei die Taktrückgewinnung allein auf digitalem Wege erfolgt und Signalwechsel zumindest eines vorgegebenen Signalwechseltyps des Datensignals erkannt werden und bei jedem Signalwechsel ein Puls (P1) erzeugt wird,
**dadurch gekennzeichnet, dass**
mit einem freilaufenden Taktgenerator (40), dessen Generatorfrequenz ein vorgegebenes Vielfaches der nominalen Taktfrequenz des Datensignals aufweist, ein Ausgangssignal erzeugt wird und die Signalwechsel des Datensignals durch ein Überabtasten mit der Generatorfrequenz erkannt werden, wobei das vorgegebene Vielfache ein ganzzahliges Vielfaches ist und mindestens drei beträgt.

10. Verfahren nach Anspruch 9,
**dadurch gekennzeichnet, dass**
- mit der Generatorfrequenz das Datensignal abgetastet wird und Signalwechsel zumindest eines vorgegebenen Signalwechseltyps des Datensignals erkannt werden und bei jedem Signalwechsel ein Puls (P1) erzeugt wird,
- mit der nominalen Taktfrequenz des Datensignals außerdem Hilfspulse (P2) erzeugt werden und
- bei Vorliegen eines Pulses (P1) oder eines Hilfspulses (P2) jeweils ein Ausgangspuls gebildet und mit den so gebildeten Ausgangspulsen das rückgewonnene Taktsignal (Q0) erzeugt wird.

## Claims

1. Clock signal recovery device (10) with a digital data signal input (E10) for feeding in a digital data signal (DATA) and with a clock signal output (T10) for outputting a recovered clock signal (Q0), wherein the digital data signal has a predetermined nominal clock signal frequency, wherein the clock signal recovery device is formed by a digital circuit and has a signal change detector (20), which detects signal changes of at least one predetermined type of signal change of the data signal and generates a pulse (P1) with each signal change, **characterized in that**
- the clock signal recovery device comprises a free-running clock generator (40), the generator frequency of which has a predetermined multiple of the nominal clock signal frequency of the data signal, wherein the predetermined multiple is an integral multiple and is at least three, and
- the output signal (T) of the clock generator is applied to the signal change detector which detects the signal changes of the data signal by oversampling with the generator frequency.

2. Clock signal recovery device according to Claim 1, **characterized in that** the clock signal recovery device has:
- an auxiliary pulse generating device (70) which generates auxiliary pulses (P2) with the nominal clock frequency of the data signal, and
- an output device (100) connected to the signal change detector and the auxiliary pulse generating device, which in each case forms an output pulse when a pulse (P1) is present and when an auxiliary pulse (P2) is present and generates the recovered clock signal (Q0) with the output pulses thus formed.

3. Clock signal recovery device according to Claim 2, **characterized in that** the auxiliary pulse generating device is connected at its input to an output (100) of the output device (A100) and is designed in such a manner that the timing of the generation of the auxiliary pulses (P2) is controlled by output pulses of the recovered clock signal (Q0).

4. Clock signal recovery device according to Claim 2 or 3, **characterized in that** the auxiliary pulse generating device is designed in such a manner that it generates an auxiliary pulse (P2) in each case after expiry of the duration of a period corresponding to the nominal clock signal frequency - or a multiple thereof - after an output pulse of the recovered clock signal (Q0).

5. Clock signal recovery device according to one of the preceding Claims 2-4, **characterized in that** the output device is formed by a flip flop (100).

6. Clock signal recovery device according to Claim 5, **characterized in that** the flip flop (100), together with the auxiliary pulse generating device, forms a binary counter which can count at least up to the predetermined multiple in binary notation.

7. Clock signal recovery device according to one of the preceding claims, **characterized in that** the digital circuit is formed exclusively by digital gates or flip flops.

8. Clock signal recovery device according to one of the preceding claims, **characterized in that** the digital circuit is implemented in an FPGA or ASIC chip.

9. Method for generating a recovered clock signal (Q0) from a digital data signal (DATA) which has a predetermined nominal clock signal frequency, wherein the clock signal recovery is carried out only digitally and signal changes are detected of at least one predetermined type of signal change of the data signal and a pulse (P1) is generated with each signal change, **characterized in that** an output signal is generated with a free-running clock generator (40), the generator frequency of which has a predetermined multiple of the nominal clock signal frequency of the data signal, an output signal is generated and the signal changes of the data signal are detected by oversampling with the generator frequency, wherein the predetermined multiple is an integral multiple and is at least three.

10. Method according to Claim 9, **characterized in that**
- the data signal is sampled with the generator frequency and signal changes of at least one predetermined type of signal change of the data signal are detected and a pulse (P1) is generated with each signal change,
- auxiliary pulses (P2) are also generated with the nominal clock frequency and
- when a pulse (P1) or an auxiliary pulse (P2) is present, an output pulse is formed in each case and the recovered clock signal (Q0) is generated by means of the output pulses thus formed.

## Revendications

1. Dispositif ( 10 ) de récupération d'horloge comprenant une entrée ( E10 ) de signal de donnée numérique pour l'injection d'un signal ( DATA ) de donnée numérique et une sortie ( T10 ) d'horloge pour la sortie d'un signal ( Q0 ) d'horloge récupéré, le signal de donnée numérique ayant une fréquence d'horloge nominale prescrite, dans lequel le dispositif de récupération d'horloge est formé par un circuit numérique et comporte un dispositif ( 20 ) de reconnaissance de changement de signal, qui reconnaît le changement de signal d'au moins un type de changement de signal prescrit du signal de donnée et qui produit une impulsion ( P1 ) à chaque changement de signal,
**caractérisé en ce que**
- le dispositif de récupération d'horloge comprend un générateur ( 40 ) de cadence non asservi, dont la fréquence est un multiple prescrit de la fréquence d'horloge nominale du signal de donnée, le multiple prescrit étant un multiple en nombre entier et au moins égal à trois, et
- le dispositif de reconnaissance de changement de signal est alimenté en le signal ( T ) de sortie du générateur de cadence et reconnaît le changement du signal de donnée par un suréchantillonnage à la fréquence du générateur.

2. Dispositif de récupération d'horloge suivant la revendication 1, **caractérisé en ce que**
le dispositif de récupération d'horloge comporte :
- un dispositif ( 70 ) de production d'impulsions auxiliaires, qui produit des impulsions ( P2 ) auxiliaires à la fréquence d'horloge nominale du signal de donnée, et
- un dispositif ( 100 ) d'émission, en communication avec le dispositif de reconnaissance de changement de signal et avec le dispositif de production d'impulsions auxiliaires, qui, en présence d'une impulsion ( P1 ) et en présence d'une impulsion ( P2 ) auxiliaire, forme respectivement une impulsion de sortie et produit le signal ( Q0 ) d'horloge récupéré avec les impulsions de sortie ainsi formées.

3. Dispositif de récupération d'horloge suivant la revendication 2, **caractérisé en ce que** le dispositif de production d'impulsions auxiliaires est en liaison du côté de l'entrée avec une sortie ( 100 ) du dispositif ( A100 ) d'émission et est constitué de manière à ce que la production des impulsions ( P2 ) auxiliaires soit commandée dans le temps par des impulsions de sortie du signal ( Q0 ) d'horloge récupéré.

4. Dispositif de récupération d'horloge suivant la revendication 2 ou 3, **caractérisé en ce que** le dispositif de production d'impulsions auxiliaires est conformé de manière à produire, après écoulement d'une durée correspondant à la fréquence d'horloge nominale ou d'un multiple de celle-ci, respectivement une impulsion ( P2 ) auxiliaire après une impulsion de sortie du signal ( Q0 ) d'horloge récupéré.

5. Dispositif de récupération d'horloge suivant l'une des revendications précédentes 2 à 4, **caractérisé en ce que** le dispositif d'émission est formé par une bascule ( 100 ).

6. Dispositif de récupération d'horloge suivant la revendication 5, **caractérisé en ce que** la bascule ( 100 ) forme, conjointement avec le dispositif de production d'impulsions auxiliaires, un compteur binaire qui peut compter de manière binaire au moins jusqu'au multiple prescrit.

7. Dispositif de récupération d'horloge suivant l'une des revendications précédentes, **caractérisé en ce que** le circuit numérique est formé exclusivement par des portes numériques ou par des bascules.

8. Dispositif de récupération d'horloge suivant l'une des revendications précédentes, **caractérisé en ce que** le circuit numérique est réalisé en un module FPGA ou en un module ASIC.

9. Procédé de production d'un signal ( Q0 ) d'horloge récupéré, composé d'un signal ( DATA ) de donnée numérique, qui a une fréquence d'horloge nominale prescrite, la récupération d'horloge s'effectuant seulement de façon numérique et un changement de signal d'au moins un type de changement de signal prescrit du signal de donnée étant reconnu et une impulsion ( P1 ) étant produite à chaque changement de signal,
**caractérisé en ce que** l'on produit un signal de sortie par un générateur ( 40 ) de cadence non asservi, dont la fréquence est un multiple prescrit de la fréquence nominale du signal de donnée et on reconnaît le changement du signal de donnée par un suréchantillonnage à la fréquence du générateur, le multiple prescrit étant un multiple en nombre entier et étant égal au moins à trois.

10. Procédé suivant la revendication 9, **caractérisé en ce que** l'on échantillonne le signal de donnée à la fréquence du générateur et on reconnaît un changement de signal d'au moins un type de changement de signal prescrit du signal de donnée et on produit une impulsion ( P1 ) à chaque changement de signal,
- on produit en outre des impulsions ( P2 ) auxiliaires à la fréquence d'horloge nominale du signal de donnée et
- en présence d'une impulsion ( P1 ) ou d'une impulsion ( P2 ) auxiliaire, on forme respectivement une impulsion de sortie et on produit le signal ( Q0 ) d'horloge récupéré avec les impulsions de sortie ainsi formées.
